# EUROPEAN PATENT APPLICATION

(11) **EP 1 569 264 A1**
(43) Date of publication of application: **31.08.2005**
(21) Application number: 03775855.4
(22) Date of filing: 21.11.2003
(51) Int. Cl.: H01L 21/205

(54) **METHOD FOR PRODUCING SILICON EPITAXIAL WAFER**

(30) Priority: 06.12.2002 JP 2002355239
(71) Applicant: Shin-Etsu Handotai Co., Ltd, Tokyo 100-0005 (JP)
(72) Inventor: SUKA, Akihiko, Shin-Etsu Handotai Co., Ltd., Annaka-shi, Gunma 379-0196 (JP); NAKASUGI, Tadashi, Shin-Etsu Handotai Co., Ltd., Annaka-shi, Gunma 379-0196 (JP); ARAI, Takeshi, Shin-Etsu Handotai Co., Ltd., Annaka-shi, Gunma 379-0196 (JP)
(74) Representative: Jones, Helen M.M.
(86) International application number: PCT/JP2003/014914
(87) International publication number: WO 2004/055874

(57) **Abstract**

When manufacturing a silicon epitaxial wafer by forming a silicon epitaxial layer through vapor phase growth on a front surface of a semiconductor substrate W with a CVD oxide film formed on a rear surface thereof, there is used a susceptor (20) where a pocket (21) inside which the semiconductor substrate W is disposed is formed and at least one pore (22) which passes through the susceptor (20) to a rear surface thereof and is open even during the vapor phase growth is formed in a more central position than that of an outermost peripheral portion inside the pocket (21), and the semiconductor substrate W is disposed such that the CVD oxide film faces the at least one pore (22), thus forming the silicon epitaxial layer on the front surface of the semiconductor substrate W through the vapor phase growth.

## Description

### Technical Field

The present invention relates to a manufacturing method of a silicon epitaxial wafer.

### Background Art

Conventionally, vapor phase growth of an epitaxial layer on the front surface of a semiconductor substrate (hereinafter, refer to simply as a substrate) is performed by heating the substrate up to a desired growth temperature with a heating unit, and supplying reaction gas onto the front surface of the substrate with a gas supplying unit, in a state where a susceptor is provided in a reaction chamber and the substrate is disposed on this susceptor.

In this connection, when forming a low concentration epitaxial layer (thus having high resistivity) on a substrate with a high dopant concentration (thus having low resistivity) through vapor phase growth, for example, such as when forming a p⁻-type silicon epitaxial layer (hereinafter, refer to simply as an epitaxial layer) on a p⁺-type, boron (B) doped substrate through vapor phase growth, a phenomenon in which dopants once discharged into the vapor phase from inside the substrate enter the epitaxial layer (hereinafter, refer to as auto doping) occurs. Auto doping occurs due to dopants which diffuse out from inside a substrate when heated, and dopants discharged from inside a substrate when the surface of the substrate is subjected to vapor phase etching. When auto doping occurs, it causes a problem that, the farther it is from the center of an epitaxial layer after vapor phase growth, the higher a dopant concentration in the epitaxial layer becomes (on the contrary, in a case of a p⁻/p⁺ type or an n⁻/n⁺ type, the farther it is from the center thereof, the lower the resistivity becomes).

Conventionally, in order to prevent occurrence of such auto doping, an oxide film is formed through atmospheric pressure CVD (Chemical Vapor Deposition) (hereinafter, refer to simply as a CVD oxide film) on the rear surface of a substrate (see Japanese Patent Application Laid-Open No. 197128/1990).

To form a CVD oxide film on the rear surface of the substrate, an inert gas such as nitrogen is used as a carrier gas, and, in a nitrogen gas atmosphere where, for example, 0.05 to 0.15 volume% monosilane (SiH₄) and 0.5 to 1.5 volume% oxygen are mixed with the carrier gas, the substrate is heated to have a temperature in a range of 350 to 450°C. Thus, a CVD oxide film containing an OH group of 3 weight% or more is formed.

However, when a CVD oxide film is formed on the rear surface of a substrate as described above, the CVD oxide film has a porous film quality, and moisture is adsorbed in the oxide film. Therefore, when an epitaxial layer is formed through vapor phase growth, the surface of the epitaxial layer formed on the surface of the substrate becomes finely uneven due to influence of moisture desorbed from the CVD oxide film, and haze is sometimes observed under a collimated light. Such generation of haze becomes a cause of decrease in the yield.

The present invention is made in view of the above circumstances, and an object thereof is to provide a manufacturing method of a silicon epitaxial wafer in which the surface of a silicon epitaxial layer does not become finely uneven, and generation of haze can be suppressed.

### Disclosure of the Invention

As described above, in the vapor phase growth process, the surface of the epitaxial layer to be formed on the surface of the substrate becomes finely uneven due to influence of moisture desorbed from the CVD oxide film, and haze is observed under a collimated light. It can be assumed that the reason for the above is as follows.

In the susceptor, a pocket (a recessed portion having a shape close to the substrate) to dispose the substrate in a state where the position thereof is determined is formed, and the substrate is disposed in the pocket. During vapor phase growth, moisture desorbed from the CVD oxide film, in particular, from a portion of the oxide film close to a vapor phase growth gas introduction side, is attracted by a gas stream on the vapor phase growth gas introduction side to go up, and apt to go around to reach the front surface side of the substrate. The moisture then flows with vapor phase growth gas along the epitaxial layer which is to be formed on the front surface of the substrate, thereby making the surface of the epitaxial layer finely uneven.

Thus, moisture desorbed from the CVD oxide film flows through the space between the surface on the substrate supporting side of the pocket and the rear surface of the substrate, goes around to reach the front surface of the substrate, and flows along the epitaxial layer on the front surface of the substrate toward a gas discharge side. By using the susceptor with pores which pass through the susceptor to the rear surface thereof, moisture desorbed from the CVD oxide film is allowed to escape from the pores to the side below the susceptor. Japanese Patent Application Laid-Open No. 223545/1998 as an auto doping preventative measure can be taken as an example of a susceptor with pores which pass through the susceptor to the rear surface thereof.

However, pores described in Japanese Patent Application Laid-Open No. 223545/1998 are in the outermost peripheral portion of a pocket. Therefore, together with gas flowing into the pocket from the side below the susceptor, moisture desorbed from a CVD oxide film is attracted by a gas stream of a vapor phase growth gas to go up, and caused to flow along an epitaxial layer on the front surface of the substrate. As a consequent, the surface of the epitaxial layer is made finely uneven.

Moreover, in Japanese Patent Application Laid-Open No. 8198/1996 as a measure for preventing a substrate from slipping in a pocket, a susceptor in which a plurality of through-holes to degas during preparation are provided in the pocket is disclosed. Here, there is no disclosure about positions for forming the through-holes in the pocket, and, for example, when the through-holes are provided in the outermost peripheral portion of the pocket, moisture desorbed from a CVD oxide film is caused to flow along an epitaxial layer on the front surface of the substrate, as described above.

Moreover, the through-holes disclosed in Japanese Patent Application Laid-Open No. 8198/1996 are formed to be perpendicular to the susceptor. Therefore, since the substrate supported on the pocket is irradiated with radiant light directly from the rear surface side of the susceptor through the through-holes, there are points on the substrate which are directly heated through the through-holes and points heated through the susceptor. That is, points on the substrate corresponding to the through-holes are apt to be heated locally, and the temperature distribution in the substrate becomes uneven since the plurality of through-holes are formed. Consequently, the film thickness of the epitaxial layer at points on the substrate corresponding to the through-holes becomes thick, resulting in non-uniformity in the film thickness as a whole.

Thus, according to a first aspect of the present invention, a manufacturing method of a silicon epitaxial wafer of the invention is a manufacturing method of a silicon epitaxial wafer in which the silicon epitaxial wafer is manufactured by forming a silicon epitaxial layer through vapor phase growth on a front surface of a semiconductor substrate with a CVD oxide film formed on a rear surface thereof, wherein there is used a susceptor where a pocket inside which the semiconductor substrate is disposed is formed and at least one pore which passes through the susceptor to a rear surface thereof and is open even during the vapor phase growth is formed in a more central position than that of an outermost peripheral portion inside the pocket, and the semiconductor substrate is disposed such that the CVD oxide film faces the at least one pore, thus forming the silicon epitaxial layer on the front surface of the semiconductor substrate through the vapor phase growth.

Here, for the susceptor, there is one with holes through which lift pins penetrate (hereinafter, referred to as lift pin holes) formed therein. However, since the lift pin holes are closed by the head portions of the lift pins during vapor phase growth and gas is substantially unable to circulate therethrough, the lift pin holes are not relevant to the "pore that is open even during vapor phase growth." The lift pins are pins which are provided to be able to perform going up and down operation relative to the susceptor, and used for installation and removal of the semiconductor substrate on and from the susceptor along with the going up and down operation in a state of supporting the semiconductor substrate from the rear surface side thereof.

According to the manufacturing method of a silicon epitaxial wafer in accordance with the first aspect of the present invention, there is used a susceptor where at least one pore which passes through the susceptor to a rear surface thereof and is open even during the vapor phase growth is formed in a more central position than that of an outermost peripheral portion inside the pocket, and the semiconductor substrate is disposed such that the CVD oxide film faces the at least one pore, thus forming the silicon epitaxial layer on the front surface of the semiconductor substrate through the vapor phase growth. Accordingly, moisture desorbed from the CVD oxide film on the rear surface of the semiconductor substrate due to heating during the vapor phase growth can be smoothly discharged through the pore to the side below the susceptor. Thus, the surface of the epitaxial layer is not influenced by the moisture desorbed from the CVD oxide film and does not become finely uneven, and generation of haze can be suppressed.

In other words, since the pore is formed in a more central position than that of the outermost peripheral portion inside the pocket so as to face the CVD oxide film and is covered by the substrate, moisture is hardly attracted by a gas stream of a vapor phase gas together with gas flowing through the pore into the pocket from the side below the susceptor, and thus hardly goes up. Therefore, moisture from the CVD oxide film hardly goes around to reach the front surface of the substrate, and generation of haze can be suppressed.

Preferably, the at least one pore is formed only in a position or positions which face a peripheral portion of the rear surface of the semiconductor substrate.

In this invention, by forming at least one pore only in a position or positions which face the peripheral portion of the substrate, influence of radiant light from the rear surface side of the susceptor can be suppressed to the minimum. Additionally, since moisture discharged due to heating or the like from the CVD oxide film formed on the rear surface of the semiconductor substrate can be discharged through the pore to the side below the susceptor before going around to reach the front surface side of the semiconductor substrate, generation of haze can be suppressed while influence of radiant light from the rear surface side of the susceptor is suppressed to the minimum.

Further, according to a second aspect of the present invention, a manufacturing method of a silicon epitaxial wafer of the invention is a manufacturing method of a silicon epitaxial wafer in which the silicon epitaxial wafer is manufactured by forming a silicon epitaxial layer through vapor phase growth on a front surface of a semiconductor substrate with a CVD oxide film formed on a rear surface thereof, wherein there is used a susceptor where a pocket inside which the semiconductor substrate is disposed is formed, the pocket has a two-step structure including an upper pocket portion which supports a peripheral portion of the semiconductor substrate and a lower pocket portion formed in a more central and lower position than that of the upper pocket portion, and at least one pore which passes through the susceptor to a rear surface thereof and is open even during the vapor phase growth is formed in the lower pocket portion, and the semiconductor substrate is disposed such that the CVD oxide film faces the at least one pore, thus forming the silicon epitaxial layer on the front surface of the semiconductor substrate through the vapor phase growth.

According to the manufacturing method of a silicon epitaxial wafer in accordance with the second aspect of the present invention, the pore formed in the lower pocket portion formed in a more central position than that of the upper pocket portion which supports the peripheral portion of the semiconductor substrate is naturally placed in a more central position than that of the outermost peripheral portion inside the pocket. Accordingly, through this pore, moisture desorbed from the CVD oxide film can be smoothly discharged to the side below the susceptor. Thus, the surface of the epitaxial layer hardly becomes finely uneven, and generation of haze can be suppressed.

Preferably, the at least one pore includes an overheat suppression portion which suppresses local overheat in the semiconductor substrate by preventing radiation of heat which radiates directly through the at least one pore from a heat source which heats the semiconductor substrate from a rear surface side thereof.

Here, if the pore has a linear shape that is perpendicular to a plate surface of the susceptor, heat radiates directly from a heat source through the pore to the semiconductor substrate supported by the susceptor, and a point on the semiconductor substrate corresponding to the pore is apt to be overheated locally. Consequently, the film thickness of the silicon epitaxial layer becomes thick at a point on the semiconductor substrate corresponding to the pore. However, in the present invention, the pore includes the overheat suppression portion, and thus direct heat radiation from the heat source through the pore to the semiconductor substrate can be prevented. Thus, local overheat in the semiconductor substrate is suppressed, and the film thickness of the silicon epitaxial layer can be made uniform.

Preferably, the overheat suppression portion is provided by forming the at least one pore in a cranked shape.

The overheat suppression portion may be provided by making the at least one pore be linearly inclined relative to a thickness direction of the susceptor. Further, the overheat suppression portion may be provided by making the at least one pore be curved relative to a thickness direction of the susceptor.

### Brief Description of the Drawings

FIG. 1 is a schematic front sectional view showing a vapor phase growth apparatus particularly in a state of vapor phase growth;
FIG. 2 is a schematic front sectional view showing the vapor phase growth apparatus particularly in a state where a substrate is supported above the susceptor by lift pins;
FIG. 3A is a front sectional view showing an example of a susceptor;
FIG. 3B is a plan view of the susceptor shown in FIG. 3A;
FIG. 4 is a front sectional view showing an example of a susceptor;
FIG. 5A is a front sectional view showing an example of a susceptor;
FIG. 5B is a plan view of the susceptor shown in FIG. 5A;
FIG. 6A is a front sectional view showing an example of a susceptor;
FIG. 6B is a plan view of the susceptor shown in FIG. 6A;
FIG. 7A is a front sectional view showing an example of a susceptor;
FIG. 7B is a plan view of the susceptor shown in FIG. 7A;
FIG. 8A is a front sectional view showing an example of a susceptor;
FIG. 8B is a plan view of the susceptor shown in FIG. 8A;
FIG. 9A is a front sectional view showing an example of a susceptor;
FIG. 9B is a plan view of the susceptor shown in FIG. 9A;
FIG. 10A is a front sectional view showing an example of a susceptor; and
FIG. 10B is a plan view of the susceptor shown in FIG. 10A.

### Best Modes for Carrying Out the Invention

Hereinbelow, embodiments according to the present invention will be described based on the drawings.

### (First Embodiment)

First, a description will be given of a structure of a single-wafer-type vapor phase growth apparatus as a preferred example of a vapor phase growth apparatus used in a manufacturing method of a silicon epitaxial wafer according to the invention.

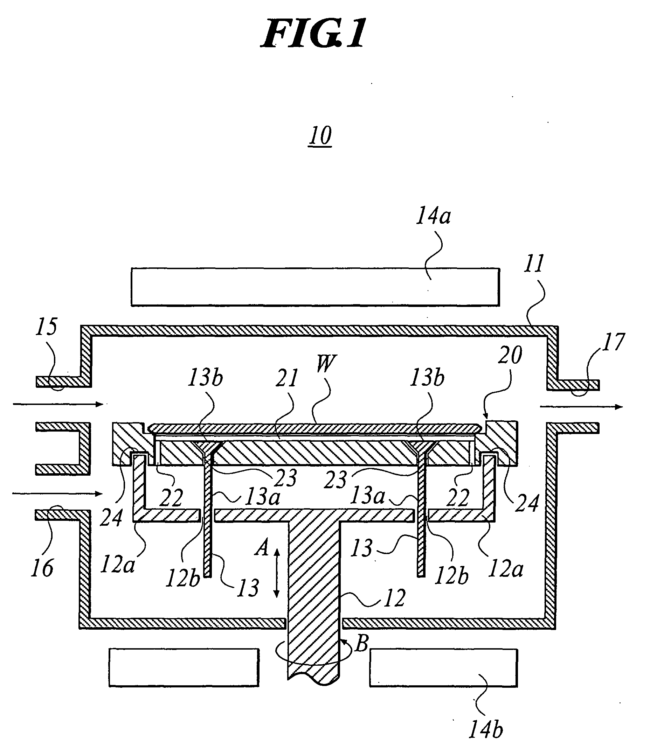

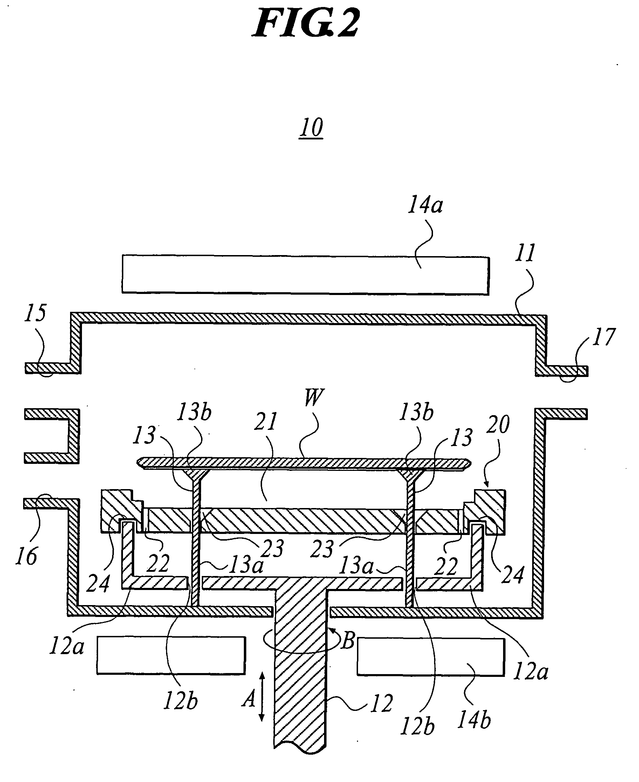

As shown in FIGS. 1 and 2, a vapor phase growth apparatus 10 includes a reaction chamber 11, a susceptor 20, a susceptor support member 12, lift pins 13, heating units 14a and 14b, a vapor phase growth gas introduction pipe 15, a purge gas introduction pipe 16, an exhaust pipe 17, and the like.

The reaction chamber 11, inside which the susceptor 20 is provided, is a place where a piece of semiconductor substrate W disposed on the susceptor 20 is subjected to heat treatment under a hydrogen atmosphere, and a silicon epitaxial layer is formed on the front surface of the substrate W through vapor phase growth.

The susceptor 20 supports the substrate W when performing silicon vapor phase epitaxial growth, and is made up of, for example, graphite coated with silicon carbide. The susceptor 20 is, for example, formed in a substantially circular plate shape, and, on the front surface thereof, a pocket 21, which is a recessed portion having a circular shape in plan view, which is used to position the substrate W on the aforementioned front surface is formed.

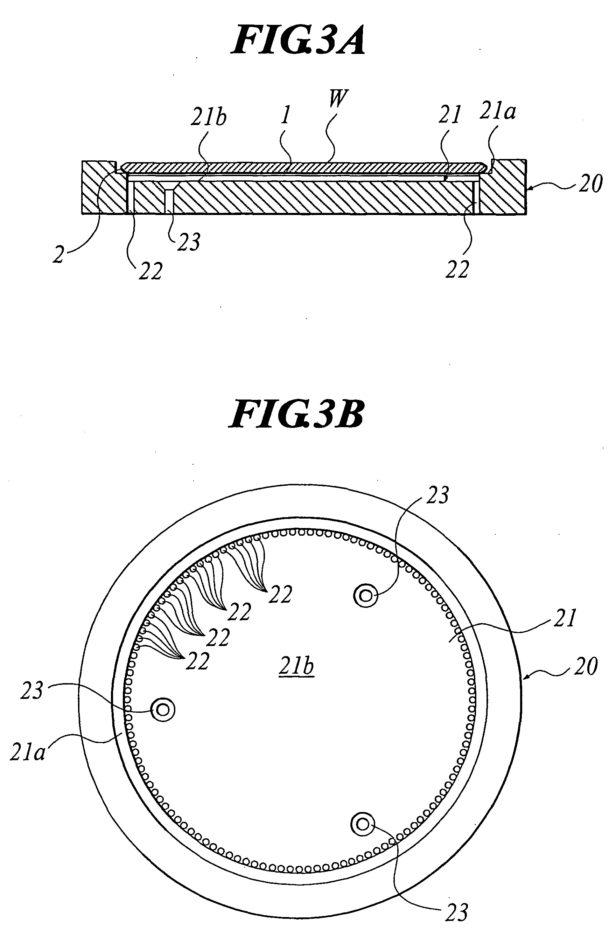

The pocket 21 has, for example, as shown in FIGS. 3A and 3B, a two-step structure including a ring-shaped upper pocket portion 21a which supports the peripheral portion of the substrate W, and a lower pocket portion 21b which is formed in a more central and lower position than that of the upper pocket portion 21a. Both the upper pocket portion 21a and the lower pocket portion 21b are formed, for example, to be substantially flat.

Only on the circumference of the outermost peripheral portion of the lower pocket portion 21b, a plurality of pores 22, which pass through the susceptor 20 to the rear surface thereof and are in an open state even during vapor phase growth, are formed at even intervals. Here, the pores 22 of the lower pocket portion 21b, which is formed in a more central position than that of the ring-shaped upper pocket portion 21a that supports the peripheral portion of the substrate W, are naturally placed in more central positions than that of the outermost peripheral portion of the pocket 21 which corresponds to the outermost peripheral portion of the upper pocket portion 21a, and face the peripheral portion of the rear surface of the substrate W.

Moreover, as described later, the substrate W is disposed such that a CVD oxide film 1 faces these pores 22, and a silicon epitaxial layer is formed on the front surface of the substrate W through vapor phase growth.

The susceptor support member 12 supports the susceptor 20 from the rear surface of the susceptor 20, and is provided so as to be able to go up and down in a direction shown by an arrow A as well as to be rotatable in a direction shown by an arrow B. A plurality of support arms 12a are provided to be branched radially from the top end portion of the susceptor support member 12.

The top end portions of the support arms 12a are fitted into recessed portions 24 (illustration omitted in FIGS. 3A to 10B) formed on the rear surface of the susceptor 20, thereby supporting the susceptor 20 such that the top surface thereof is substantially horizontal.

Each of the lift pins 13 includes a body portion 13a formed in a rod shape, and a head portion 13b which is formed at the top end portion of the body portion 13a to support the substrate W mounted on the pocket 21 from the rear surface side thereof. The diameter of the head portion 13b is made larger than that of the body portion 13a so that the substrate W can be supported easily.

The lift pins 13 are inserted into lift pin holes 23 formed on the bottom surface of the pocket 21, and placed such that the head portions 13b thereof are at the bottom surface of the pocket 21. Moreover, the body portions 13a of the lift pins 13 are through the through-holes 12b formed in the support arms 12a.

The heating units 14a and 14b are devices which heat the substrate W mounted on the susceptor 20 up to a desired growth temperature. A halogen lamp and the like can be given as examples of the heating units 14a and 14b.

Through the vapor phase growth gas introduction pipe 15, a vapor phase growth gas containing a source gas (for example, trichlorosilane) and a carrier gas (for example, hydrogen) is introduced to a region above the susceptor 20 in the reaction chamber 11 to be supplied onto the front surface of the substrate W on the susceptor 20.

The purge gas introduction pipe 16 and the vapor phase growth gas introduction pipe 15 are disposed on the same side of the reaction chamber 11, and a purge gas (for example, hydrogen) is introduced through the purge gas introduction pipe 16 to a region under the susceptor 20 in the reaction chamber 11.

The exhaust pipe 17 is disposed on the opposite side of the reaction chamber 11 relative to the vapor phase growth gas introduction pipe 15 and the purge gas introduction pipe 16, and gas (a vapor phase growth gas and a purge gas) is discharged from the reaction chamber 11 therethrough.

Next, a description will be given of a manufacturing method of a silicon epitaxial wafer W in which, by use of the vapor phase growth apparatus 10 having the above described structure, a silicon epitaxial layer is formed through vapor phase growth on the substrate W with the CVD oxide film 1 formed on the rear surface thereof, and thus the silicon epitaxial wafer W is manufactured.

The CVD oxide film 1 is formed on the rear surface of the substrate W by atmospheric pressure CVD method. More specifically, the CVD oxide film 1 is formed by heating the substrate W in a growth gas atmosphere in which monosilane (SiH₄) and oxygen are mixed to a predetermined ratio with an inert gas such as nitrogen gas that serves as a carrier gas.

First, the substrate W is going to be supported on the susceptor 20 in the reaction chamber 11 as shown in FIG. 1.

For this, in order to hand over the substrate W onto the lift pins 13, the respective lift pins 13 are raised by substantially the same amount as each other relative to the susceptor 20 so as to protrude above the top surface of the susceptor 20. In other words, the susceptor 20 is lowered along with an operation of lowering the susceptor support member 12, the bottom end portions of the lift pins 13 reach the inner bottom surface of the reaction chamber 11 in the course of this lowering, and, while the lift pins 13 cannot be lowered any further, the susceptor 20 is further lowered. Thus, the lift pins 13 are raised relative to the susceptor 20, and in due course it comes to a state of FIG. 2 but there is no substrate W.

In a state where the lift pins 13 are thus raised relative to the susceptor 20, the substrate W is conveyed into the reaction chamber 11 by a handler (not shown), and, with the front surface up, the substrate W is supported on the head portions 13b of the respective lift pins 13.

Then, while the handler is put back, the susceptor 20 is raised along with the susceptor support member 12 being raised up, and when the peripheral portion of the pocket 21 reaches the rear surface of the substrate W in the course of this raising-up, the substrate W, which has so far been supported on the head portions 13b of the lift pins 13, is brought into a state of being supported on the peripheral portion of the pocket 21. At this time, the CVD oxide film 1 formed on the rear surface of the substrate W is placed so as to face the pores 22 of the susceptor 20.

Moreover, when the brims of the lift pin holes 23 reach the head portions 13b of the lift pins 13, the lift pins 13, which have so far been in a state of being supported on the inner bottom surface of the reaction chamber 11, are brought into a state of being supported on the susceptor 20 (see FIG. 1).

When the substrate W is thus supported on the susceptor 20, vapor phase growth is performed.

The susceptor support member 12 is driven to rotate on the vertical axis thereof, whereby the susceptor 20 and the substrate W are rotated. Then, electric power is supplied to the heating units 14a and 14b to heat the substrate W on the susceptor 20 up to a desired growth temperature, and, while this temperature is maintained, a vapor phase growth gas is supplied substantially horizontally onto the front surface of the substrate W through the vapor phase growth gas introduction pipe 15. Meanwhile, hydrogen is introduced below the susceptor 20 through the purge gas introduction pipe 16. Thus, during the vapor phase growth, a stream of the vapor phase growth gas and a stream of the purge gas are formed above and below the susceptor 20, respectively, to be in substantially parallel to the susceptor 20 and the substrate W.

By performing vapor phase growth in this way, a silicon epitaxial layer is formed on the front surface of the substrate W, and thus the silicon epitaxial wafer W can be manufactured.

Here, in this embodiment, the CVD oxide film 1 is formed on the rear surface of the substrate W disposed on the susceptor 20, and therefore, by heating the substrate W during vapor phase growth, moisture adsorbed inside the CVD oxide film 1 is desorbed from the CVD oxide film 1 to be discharged therefrom.

In this regard, as described above, in the susceptor 20 used in this embodiment, the pores 22 which pass through the susceptor 20 to the rear surface thereof are formed so as to face the CVD oxide film, and therefore, moisture desorbed from the CVD oxide film 1 can be smoothly discharged from the rear surface side of the susceptor 20 through the pores 22. Thus, the moisture does not go around to reach the front surface side of the substrate W. Accordingly, the silicon epitaxial layer hardly becomes finely uneven, and haze can be suppressed.

Moreover, since the pores 22 are formed at the positions facing the peripheral portion of the rear surface of the substrate W, while influence of radiant light from the rear surface side of the susceptor 20 is suppressed to the minimum, moisture can be discharged to the side below the susceptor 20 through the pores 22 before going around to reach the front surface side of the substrate W.

Further, in a state where the substrate W is supported on the upper pocket portion 21a, a small space is formed between the rear surface of the substrate W and the lower pocket portion 21b, and moisture is enabled to gently circulate through the space. Thus, even when the pores 22 are formed only in part of the lower pocket portion 21b (for example, the outermost peripheral portion), moisture desorbed from the CVD oxide film 1 can be smoothly discharged.

When the silicon epitaxial wafer W has been manufactured, the manufactured silicon epitaxial wafer W is unloaded to the outside of the reaction chamber 11.

More specifically, rotation of the susceptor 20 is stopped in advance, the susceptor support member 12 is then lowered, the respective lift pins 13 are caused to perform projection operation to project above the susceptor 20 by substantially the same amount as each other as shown in FIG. 2, and the substrate W is raised above the pocket 21 of the susceptor 20 along with the projection operation. Subsequently, the substrate W is unloaded by the handler (not shown).

Next, using the aforementioned susceptor 20 and a susceptor without the pores 22 (hereinafter, referred to as a poreless susceptor; not shown), silicon epitaxial wafers W were each manufactured by forming a silicon epitaxial layer on the front surface of a silicon single crystal substrate (hereinafter, referred to simply as a substrate) W through vapor phase growth. It is assumed that the poreless susceptor has the same structure as that of the susceptor 20 except that the poreless susceptor does not have the pores 22.

First, the CVD oxide film 1 with a film thickness of 500 to 800 nm was formed by atmospheric pressure CVD method on the rear surface of each of the substrates W which are of a p type, have a diameter of 200 mm, resistivity of approximately 0.01 to 0.02 Ω·cm, and (100) surface orientation. Using nitrogen gas as the carrier gas, the CVD oxide film 1 was formed by heating the respective substrates W up to approximately 350 to 450°C in a reaction gas atmosphere in which 0.05 to 0.15 volume% monosilane and 0.5 to 1.5 volume% oxygen were mixed. In the CVD oxide film 1 thus obtained, an OH group of approximately 3 weight% was contained.

Subsequently, the substrates W with the CVD oxide film 1 formed thereon were each disposed on the susceptor 20 and the poreless susceptor, and a silicon epitaxial layer of a p type with resistivity of approximately 10 Ω·cm and a thickness of approximately 6 µm was formed thereon through vapor phase growth, whereby silicon epitaxial wafers W were manufactured.

As a result, the percentage defective due to haze was 0% when the susceptor 20 with the pores 22 was used, while the percentage defective due to haze was 3.6% when the poreless susceptor was used.

It can be said that this prominently expresses that, compared with the case of the poreless susceptor, when the susceptor 20 with the pores 22 formed in the lower pocket portion 21b was used, moisture desorbed from the CVD oxide film 1 was prevented from going around to reach the front surface side of the substrate W and to circulate along the epitaxial layer on the front surface of the substrate, whereby the surface of the epitaxial layer does not become uneven and generation of haze was suppressed.

As described above, according to the manufacturing method of the silicon epitaxial wafer W of the embodiment in accordance with the present invention, there is used the susceptor 20 in which the pores 22 that pass through the susceptor 20 to the rear surface thereof and are open even during vapor phase growth are formed in the lower pocket portion 21b, that is, a more central portion than the outermost peripheral portion inside the pocket 21, the substrate W is disposed such that the CVD oxide film 1 faces the pores 22, and thus a silicon epitaxial layer is formed on the front surface of the substrate W through vapor phase growth. Therefore, moisture desorbed from the CVD oxide film 1 on the rear surface of the substrate W due to heating during vapor phase growth can be smoothly discharged to the side below the susceptor 20 through the pores 22. Hence, moisture desorbed from the CVD oxide film 1 does not influence the epitaxial layer to have an uneven surface, and generation of haze can be suppressed.

In this embodiment, the susceptor 20 shown in FIGS. 3A and 3B is used; however, for example, susceptors to be illustrated below may be used.

### (Second Embodiment)

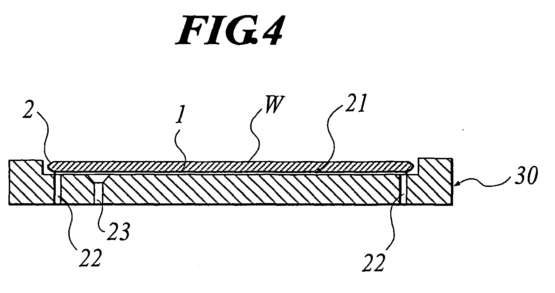

Hereinabove, the description has been made of the susceptor 20 having the two-step structure in which the pocket 21 includes the upper pocket portion 21a and the lower pocket portion 21b. However, the present invention is not limited thereto, and it is sufficient if the pores 22 are placed in a more central position than that of the outermost peripheral portion of the pocket 21. For example, as shown in FIG. 4, the susceptor may be a susceptor 30 in which the pocket 21 includes only one step.

More specifically, as shown in FIG. 4, the plurality of pores 22 may be formed in positions facing the rear surface of the substrate W which rear surface is in a more central position than that of a chamfered portion 2 of the substrate W. Further, the plurality of pores 22 may be placed on the circumference of a circle which is substantially concentric with the pocket 21.

### (Third Embodiment)

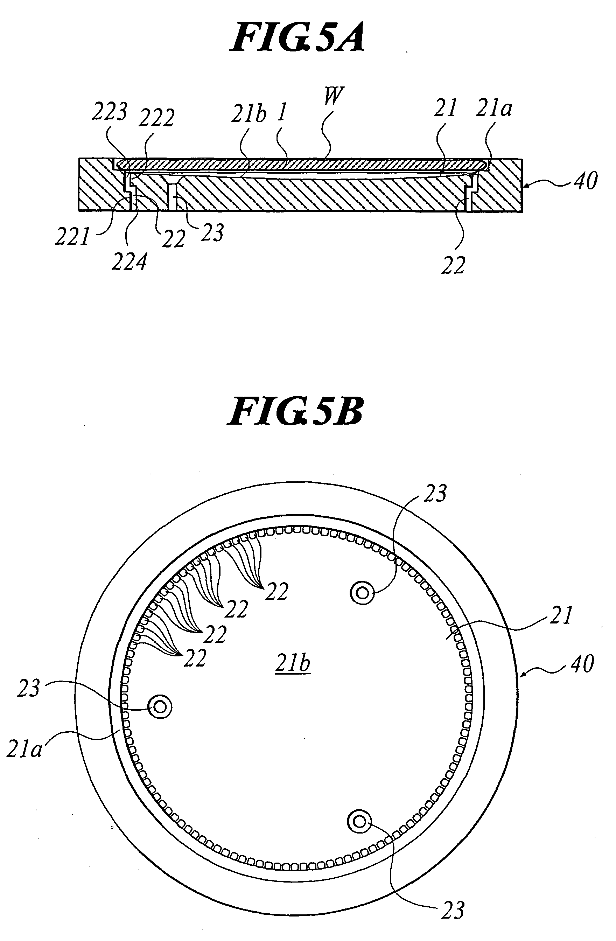

Hereinabove, the pores 22 of the both cases are provided so as to be parallel to the thickness directions of the susceptors 20 and 30. However, as shown in FIGS. 5A and 5B, the susceptor may be a susceptor 40 in which the pores 22 are in a cranked shape.

The susceptor 40 shown in FIGS. 5A and 5B is different from the susceptor 20 shown in FIGS. 3A and 3B in that the lower pocket portion 21b is formed in a concavely curved shape. Moreover, the shape of the pores 22 is different from that of the pores 22 of the susceptor 20. The susceptor 40 is otherwise the same as the susceptor 20, and the same constituent elements will be designated by the same reference numerals, thus omitting the description thereof.

Each of the pores 22 of the susceptor 40 includes overheat suppression portions 221 and 222 which suppress local overheat in the substrate W by preventing radiation of heat which radiates directly through the pores 22 from a heat source (in particular, the heating unit 14b) that heats the substrate W from the rear surface side thereof.

The overheat suppression portions 221 and 222 are provided by forming the pores 22 in a cranked shape. In other words, in the lower pocket portion 21b, from the surface of the side for supporting the substrate W and from the opposite surface thereto, pore portions 223 and 224 whose positions are deviated from each other and only part thereof overlap each other are formed, respectively, so as not to pass through the susceptor 40 but deep enough to communicate with each other inside the susceptor 40, thus forming the respective pores 22 in a cranked shape. In this way, the portion where the pore portion 223 ends forms the overheat suppression portion 221, and the portion where the pore portion 224 ends forms the overheat suppression portion 222.

The overheat suppression portions 221 and 222 may be applied to the susceptor 30 in which the pocket 21 includes only one step.

Thus, since each of the pores 22 includes the overheat suppression portions 221 and 222, direct heat radiation from the heat source (heating unit 14b) through the pores 22 to the substrate W can be prevented. Accordingly, local overheat in the substrate W can be suppressed, and the film thickness of the silicon epitaxial layer can be made uniform.

### (Fourth Embodiment)

Susceptors shown in FIGS. 6A to 8B are different from the susceptor 40 only in the shape of the pores 22. The susceptors are otherwise the same as the susceptor 40, and the same constituent elements are designated by the same reference numerals, thus omitting the description thereof.

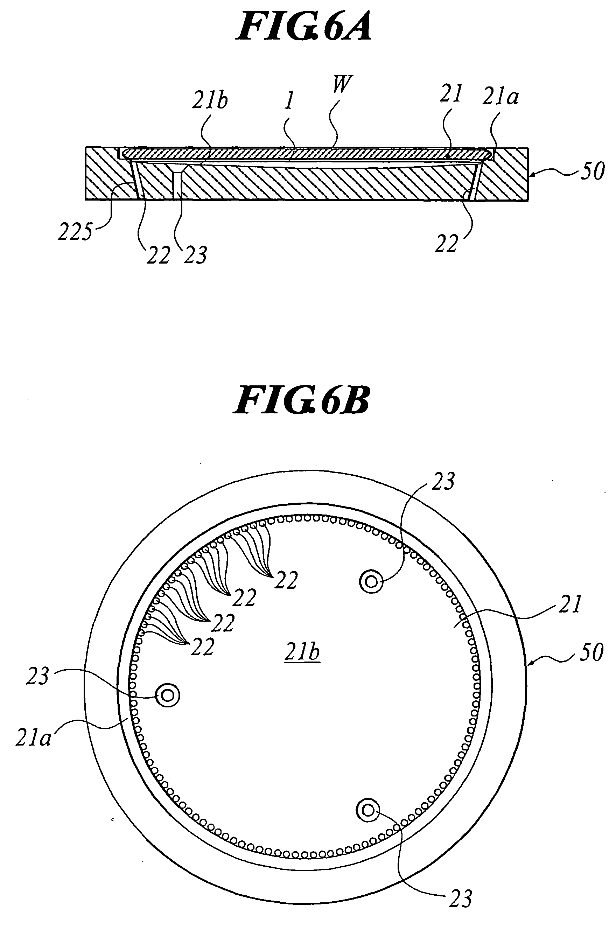

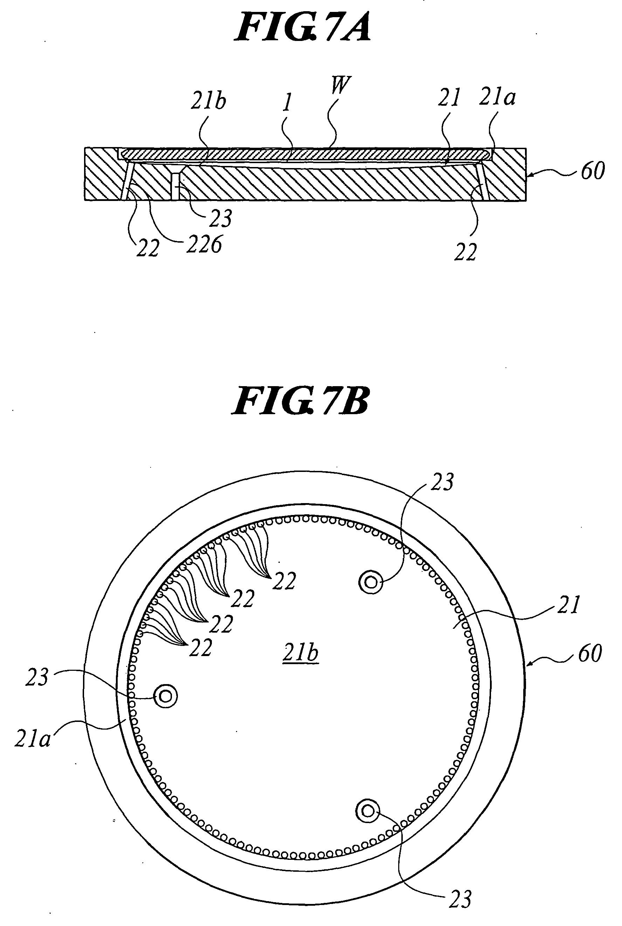

Each of the pores 22 of susceptors 50 and 60 shown in FIGS. 6A and 6B and FIGS. 7A and 7B, respectively, include overheat suppression portions 225 and 226, respectively. The overheat suppression portions 225 and 226 are provided by making the pores 22 be linearly inclined relative to the thickness directions of the susceptors 50 and 60. In other words, the edge portions of the pores 22 form the overheat suppression portions 225 and 226. As shown in FIGS. 6A, 6B, 7A and 7B, the inclination direction is arbitrary.

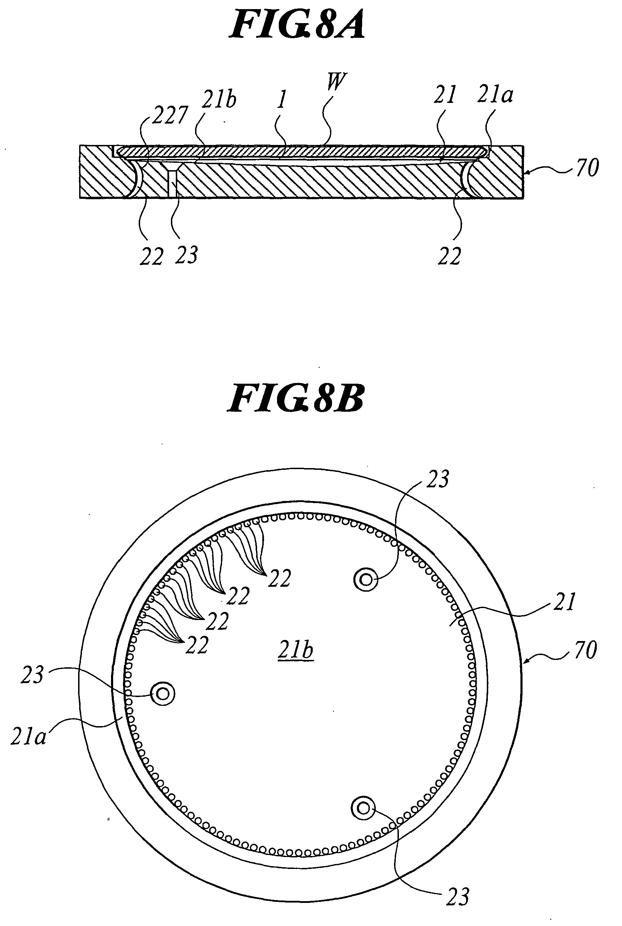

In FIGS. 8A and 8B, an overheat suppression portion 227 is provided by making the respective pores 22 be curved in a circular arc shape relative to the thickness direction of a susceptor 70. In other words, the edge portion of the respective pores 22 forms the overheat suppression portion 227.

The overheat suppression portions 225, 226 and 227 may be applied to the susceptor 30 in which the pocket 21 includes only one step.

### (Fifth Embodiment)

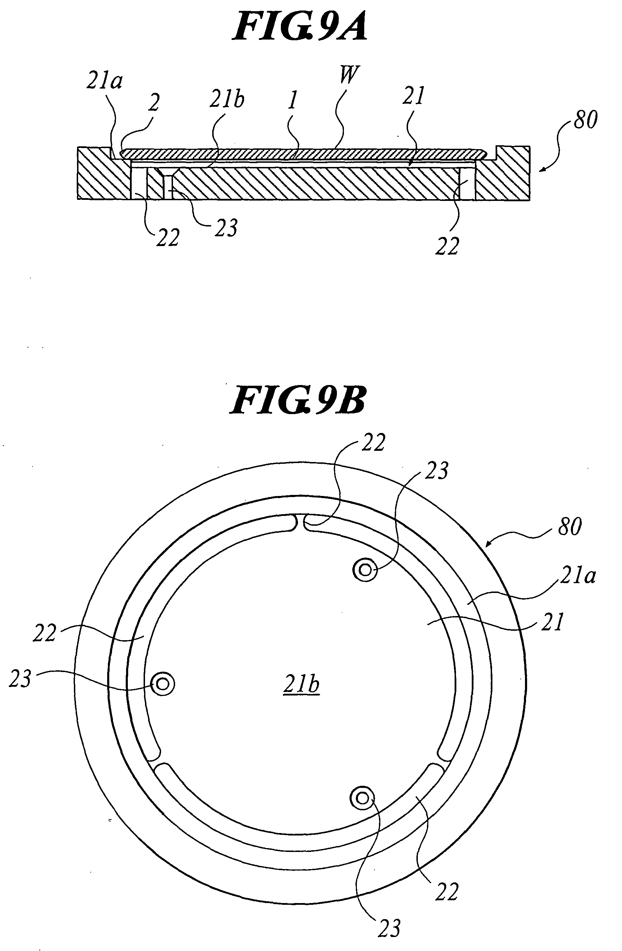

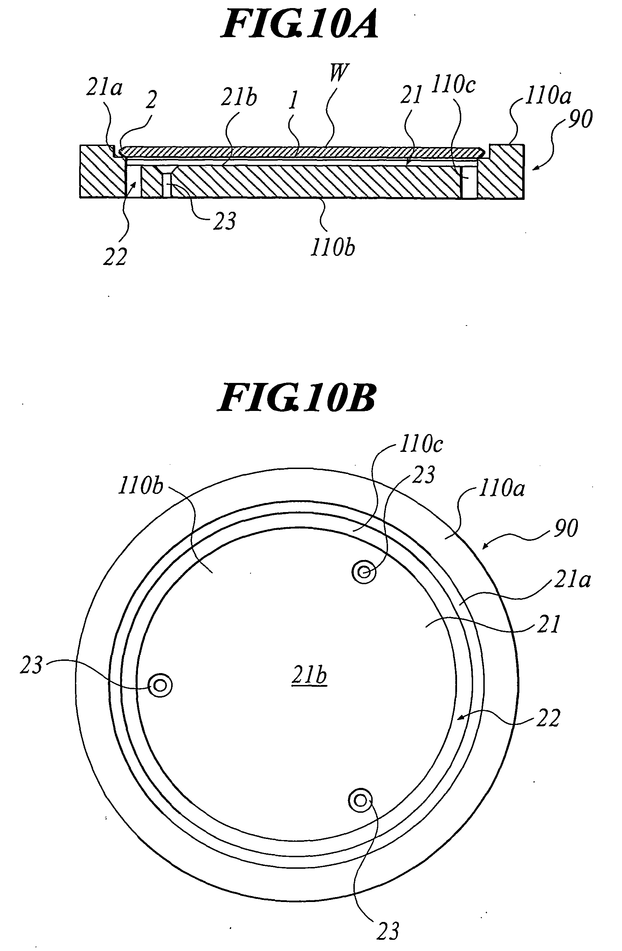

Hereinabove, the description has been made of the pores 22 each having a cylindrical shape. However, the pores 22 may be in such a tubular shape other than a cylindrical shape that the section of the hollow of the respective pores 22 forms a rectangular shape. Alternatively, for example, the pores 22 may be in a slit shape like those of a susceptor 80 shown in FIGS. 9A and 9B, or the pores 22 may be ring-shaped like those of a susceptor 90 shown in FIGS. 10A and 10B. The susceptors 80 and 90 shown in FIGS. 9A and 9B and 10A and 10B, respectively, are different from the susceptor 20 shown in FIGS. 3A and 3B only in the shape of the pores 22. The susceptors 80 and 90 are otherwise the same as the susceptor 20, and the same constituent elements are designated by the same reference numerals, thus omitting the description thereof.

In FIGS. 9A and 9B, in the lower pocket portion 21b (for example, in the outermost peripheral portion thereof), the pores 22 which have a slit shape (that is, circular arc shape) and are along the circumference of a circle substantially concentric with the pocket 21 may be formed.

Although not shown, a plurality of slit-shaped pores 22 which are along a plurality of concentric circles whose centers are in substantially the same position as that of the pocket 21 may be formed. The slit-shaped pores 22 may be applied to the susceptor 30 in which the pocket 21 includes only one step.

In FIGS. 10A and 10B, the susceptor 90 has a divided structure where the susceptor 90 is divided into a peripheral-side portion 110a which includes the upper pocket portion 21a and the like, and an inner-circumferential-side portion 110b which forms the lower pocket portion 21b. Here, the inner diameter of an opening portion 110c in the center of the peripheral-side portion 110a is set to be larger than the outer diameter of the inner-circumferential-side portion 110b.

The inner-circumferential-side portion 110b is placed inside the opening portion 110c of the peripheral-side portion 110a so as not to be in contact with the inner circumferential wall of the opening portion 110c, whereby the ring-shaped pore 22 is formed in the space between the inner-circumferential-side portion 110b and the peripheral-side portion 110a.

The slit-shaped pores 22 and the ring-shaped pore 22 may be applied to the susceptor 30 in which the pocket 21 includes only one step.

The present invention is not limited to the above-described embodiments, and alterations can be made therein as appropriate without departing from spirit and scope of the inventions.

For example, in the above embodiments, the descriptions have been made only of the examples where the present invention is applied to the susceptors of a single wafer type. However, the present invention is not limited thereto, and may be applied to a batch process susceptor.

Further, the descriptions have been made of the examples where the susceptors include the lift pin holes. However, the present invention is not limited thereto, and the susceptors may include no lift pin hole.

### Industrial Applicability

According to the manufacturing method of a silicon epitaxial wafer of the present invention, moisture desorbed from the CVD oxide film on the rear surface of the semiconductor substrate due to heating during vapor phase growth can be smoothly discharged to the side below the susceptor through the pore(s). Thus, even with the influence of the moisture desorbed from the CVD oxide film, the surface of the epitaxial layer hardly becomes finely uneven, and generation of haze can be suppressed. Hence, the manufacturing method of a silicon epitaxial wafer according to the present invention is suitable when a CVD oxide film is formed on the rear surface of a substrate.

## Claims

1. A manufacturing method of a silicon epitaxial wafer in which the silicon epitaxial wafer is manufactured by forming a silicon epitaxial layer through vapor phase growth on a front surface of a semiconductor substrate with a CVD oxide film formed on a rear surface thereof,
wherein there is used a susceptor where a pocket inside which the semiconductor substrate is disposed is formed and at least one pore which passes through the susceptor to a rear surface thereof and is open even during the vapor phase growth is formed in a more central position than that of an outermost peripheral portion inside the pocket, and
the semiconductor substrate is disposed such that the CVD oxide film faces the at least one pore, thus forming the silicon epitaxial layer on the front surface of the semiconductor substrate through the vapor phase growth.

2. The manufacturing method of a silicon epitaxial wafer as claimed in claim 1, wherein the at least one pore is formed only in a position or positions which face a peripheral portion of the rear surface of the semiconductor substrate.

3. A manufacturing method of a silicon epitaxial wafer in which the silicon epitaxial wafer is manufactured by forming a silicon epitaxial layer through vapor phase growth on a front surface of a semiconductor substrate with a CVD oxide film formed on a rear surface thereof,
wherein there is used a susceptor where a pocket inside which the semiconductor substrate is disposed is formed, the pocket has a two-step structure including an upper pocket portion which supports a peripheral portion of the semiconductor substrate and a lower pocket portion formed in a more central and lower position than that of the upper pocket portion, and at least one pore which passes through the susceptor to a rear surface thereof and is open even during the vapor phase growth is formed in the lower pocket portion, and
the semiconductor substrate is disposed such that the CVD oxide film faces the at least one pore, thus forming the silicon epitaxial layer on the front surface of the semiconductor substrate through the vapor phase growth.

4. The manufacturing method of a silicon epitaxial wafer as claimed in any one of claims 1 to 3, wherein the at least one pore includes an overheat suppression portion which suppresses local overheat in the semiconductor substrate by preventing radiation of heat which radiates directly through the at least one pore from a heat source which heats the semiconductor substrate from a rear surface side thereof.

5. The manufacturing method of a silicon epitaxial wafer as claimed in claim 4, wherein the overheat suppression portion is provided by forming the at least one pore in a cranked shape.

6. The manufacturing method of a silicon epitaxial wafer as claimed in claim 4, wherein the overheat suppression portion is provided by making the at least one pore be linearly inclined relative to a thickness direction of the susceptor.

7. The manufacturing method of a silicon epitaxial wafer as claimed in claim 4, wherein the overheat suppression portion is provided by making the at least one pore be curved relative to a thickness direction of the susceptor.
